# EUROPEAN PATENT APPLICATION

(11) **EP 2 315 264 A1**
(43) Date of publication of application: **27.04.2011**
(21) Application number: 09806718.4
(22) Date of filing: 11.08.2009
(51) Int. Cl.: H01L 33/00

(54) **LIGHT-EMITTING DEVICE**

(30) Priority: 12.08.2008 JP 2008229048; 19.01.2009 JP 2009008916; 25.05.2009 JP 2009125428
(71) Applicant: Niiyama, Heiji, Tokyo 162-0838 (JP)
(72) Inventor: NIIYAMA, Tsubasa, Tokyo 162-0838 (JP)
(74) Representative: Gill, David Alan
(86) International application number: PCT/JP2009/064189
(87) International publication number: WO 2010/018827

(57) **Abstract**

Disclosed is a heat-resistant light-emitting device wherein luminance is increased by increasing the light emission area. A light-emitting device **1** comprises: a plate-like heat dissipation member **2**; a light-emitting body **3** emitting linear or surface light, which is mounted on the heat dissipation member **2** and has a substrate **31** and a semiconductor laminate **32** formed on substrate **31**; a fluorescent lens **4** covering the light-emitting body **3** on the heat dissipation member **2**; and a light-emitting-body-side vacuum heat insulation layer **5** formed between fluorescent lens **4** and the light-emitting body **3**. The light-emitting device **1** secures heat dissipation performance, while increasing the light emission area.

## Description

### TECHNICAL FIELD

The present invention relates to a light-emitting device which can be used as an alternative to a lighting fixture such as an incandescent lamp, a mercury lamp, a fluorescent lamp and the like.

### BACKGROUND ART

Lighting formed from electroluminescence (EL) panels and those equipped with point source light-emitting diodes (LEDs) and light guide plates are conventionally-known planar light-emitting devices. Patent document **1** proposes a point source LED improving the light resistance of phosphor, comprising an LED element housed inside a cup on top of a mount lead, an external cap covering the upper part of a blanket, and a phosphor layer applied to the inside of the external cap, wherein the inside of the cap is a vacuum or an inert gas.

In addition, Patent document **2** proposes a point source LED light-emitting device with a heat insulation layer formed in a reduced-pressure atmosphere, comprising a semiconductor light-emitting element formed of a blue LED element, a heat insulation layer covering the main light-emitting area side of the semiconductor light-emitting element, a phosphor layer disposed on the upper side of the heat insulation layer, a housing containing the semiconductor light-emitting element, a submount on top of which electrodes are arranged, and on which the semiconductor light-emitting element is mounted, two lead frames each electrically connected by the submount and a bonding wire, and a heat dissipation member.

### PRIORT ART DOCUMENTS

### PATENT DOCUMENTS

Patent document **1:** JP2004-A-352928
Patent document **2:** JP2007-A-66939

### SUMMARY OF THE INVENTION

### PROBLEMS TO BE SOLVED BY THE INVENTION

However, there is a problem that EL panels have low luminance and a complicated manufacturing process compared to LEDs. In addition, light-emitting devices using point source LEDs are relatively susceptible to heat, making it difficult to realize high luminance with large current.

The present invention takes the above-mentioned circumstances into consideration, and it is an object of the present invention to provide a heat-resistant light-emitting device capable of achieving high luminance by increasing the light emission area.

### MEANS FOR SOLVING THE PROBLEMS

In order to achieve the above-mentioned objective, the present invention provides a light-emitting device comprising: a plate-like heat dissipation member; a light-emitting body emitting linear or planar light, which is mounted on the heat dissipation member, and which has a substrate, and a semiconductor laminate extending in a predetermined direction and including a first conductivity-type first semiconductor layer, a light-emitting layer, and a second conductivity-type second semiconductor layer; a fluorescent lens covering the light-emitting body on the heat dissipation member, which emits light with a different wavelength from the light of the light-emitting body when excited by the light; a light-emitting-body-side vacuum heat insulation layer formed between the fluorescent lens and the light-emitting body; a diffusion lens covering the outside of fluorescent lens, which diffuses light passing through the fluorescent lens and; a lens-side vacuum heat insulation layer formed between the diffusion lens and the fluorescent lens; wherein the heat dissipation member extends in the same direction as the extending direction of the light-emitting body.

According to this light-emitting device, the semiconductor laminate extends in a predetermined direction, so that a relatively large current can be passed through the semiconductor laminate, and a linear or planar light-emitting body can be allowed to emit light therefrom at an arbitrary luminance. In addition, the semiconductor laminate extends in a predetermined direction, so that the light emission area can be relatively increased, and the light emission state that is approximately uniform can be realized along the extension direction of the semiconductor laminate. Most of the heat generated in the semiconductor laminate is transmitted to the heat dissipation member side, this heat is hardly transmitted to the fluorescent lens side due to heat insulation by the light-emitting-body-side vacuum heat insulation layer, so that deterioration of the fluorescent lens can be inhibited. In addition, the plate-like shape of the heat dissipation member also allows the device to be made slim. Furthermore, since the heat dissipation member extends in the same direction as the extension direction of the light-emitting body, the heat dissipation area of the heat dissipation member can be increased, and heat transmission state that is approximately uniform can be realized along the extension direction of the heat dissipation member, thus the device's heat dissipation performance can be improved.

In the light-emitting device described above, it is preferable that the light-emitting body is mounted on the center part in the width direction of the heat dissipation member.

According to the light-emitting device, heat generated from the light-emitting body is transmitted from the center side to the both end sides in the width direction of the heat dissipation member. Due to this, the heat generation can be efficiently dissipated in comparison with a case that the light-emitting body is mounted on the end parts in the width direction of the heat dissipation member.

In the light-emitting device described above, it is preferable that the light-emitting body is formed of one element extending in the predetermined direction.

According to the light-emitting device, the light-emitting body is formed of one element, so that variation in luminance, chromaticity and the like in the element is not visually recognized different from a case that the light-emitting body is formed of a plurality of elements adjacent to each other.

In the light-emitting device described above, it is preferable that the light-emitting device comprises a diffusion lens covering the outside of the fluorescent lens and diffusing the light which passes through the fluorescent lens, and a lens-side vacuum heat insulation layer formed between the diffusion lens and the fluorescent lens.

According to the light-emitting device, the light which passes through the fluorescent lens is diffused by the diffusion lens, so that the light emission state can be further homogenized. In addition, the lens-side vacuum heat insulation layer is formed, so that heat applied to the diffusion lens from is hardly transmitted to the fluorescent lens, and deterioration of the fluorescent lens due to heat generation factor at the outside of the device can be inhibited.

In the light-emitting device described above, it is preferable that the diffusion lens inhibits external ultraviolet light from penetrating.

According to the light-emitting device, it inhibits external ultraviolet light from passing through the diffusion lens so as to penetrate the fluorescent lens, so that deterioration of the fluorescent lens due to ultraviolet light can be inhibited.

In the light-emitting device described above, it is preferable that the light-emitting device comprises a heat insulating material installed on the outer edge side of the upper surface of the heat dissipation member, and the diffusion lens is installed on the heat dissipation member via the heat insulating material.

According to the light-emitting device, the heat generated in the semiconductor laminate is hardly transmitted to the diffusion lens side, so that deterioration of the diffusion lens can be inhibited.

In the light-emitting device described above, it is preferable that the diffusion lens is welded on the heat insulating material.

According to the light-emitting device, the diffusion lens and the heat insulating material can be joined together without any interstices, and in case that the inside of the diffusion lens is vacuated, airtightness thereof can be adequately ensured.

In the light-emitting device described above, it is preferable that the fluorescent lens is installed on the heat dissipation member via the heat insulating material.

According to the light-emitting device, the heat generated in the semiconductor laminate is hardly transmitted to the fluorescent lens side, so that deterioration of the fluorescent lens can be inhibited, and the color of light emitted by the device can be inhibited from changing over time.

In the light-emitting device described above, it is preferable that the fluorescent lens and the diffusion lens are made from glass.

According to the light-emitting device, the fluorescent lens and diffusion lens have enhanced resistance to heat, weather and the like in comparison with the lenses formed from resin.

In the light-emitting device described above, the light-emitting body does not have to be sealed with a sealing material.

According to the light-emitting device, the light emitted from this light-emitting device does not change over time due to the deterioration of the sealing material. In addition, the process of sealing the light-emitting body can be omitted at the time of manufacturing the device, so that the manufacturing costs can also be reduced.

### ADVANTAGES OF THE INVENTION

The light-emitting device of the present invention can cause the light-emitting body to emit either linear or planar light although it adopts a structure of LED, so that the light emission area can be increased and high luminance can be achieved, consequently it can provides a suitable alternative to a lighting fixture such as an incandescent lamp, a mercury lamp, a fluorescent lamp and the like. In addition, it can inhibit deterioration of the fluorescent lens due to heat generated in the semiconductor laminate, so that it can have high heat resistance and is capable of passing a large current through the light-emitting body. Furthermore, the heat dissipation member is formed in a plate-like shape, so that the heat emission area can be increased and the device can be slimmed down.

### BRIEF DESCRIPTION OF THE DRAWINGS

[FIG.**1]** FIG**1** is an external explanatory view showing a light-emitting device according to a first embodiment of the present invention.
[FIG.**2**] FIG.**2** is a schematic vertical sectional view showing the light-emitting device.
[FIG.**3**] FIG.**3** is a plan view showing the light-emitting device.
[FIG.**4**] FIG.**4** is a schematic vertical sectional view showing a modification of the light-emitting device.
[FIG.**5**] FIG.**5** is a schematic vertical sectional view showing a modification of the light-emitting device.
[FIG.**6**] FIG.**6** is a schematic vertical sectional view showing a light-emitting device according to a second embodiment of the present invention.
[FIG.**7**] FIG.**7** is a plan view schematically showing a semiconductor wafer.
[FIG.**8**] FIG.**8** is a schematic vertical sectional view showing a modification of the light-emitting device.

### EXPLANATION OF REFERENCE NUMERALS

- **1**: Light-emitting device
- **2**: External substrate
- **2**a: First electrode
- **2**b: Ssecond electrode
- **3**: Light-emitting body
- **3**a: First wire
- **3**b: Second wire
- **4**: Fluorescent lens
- **4**a: Fluorescent layer
- **4**b: Diffusion layer
- **5**: Light-emitting-body-side vacuum heat insulation layer
- **6**: Light reflector plate
- **7**: Sealing resin
- **8**: Phosphor
- **9**: Heat insulating material
- **16**: Reflector member
- **18**: Diffusion material
- **31**: Growth substrate
- **32**: Semiconductor laminate
- **33**: n-type semiconductor layer
- **34**: Light-emitting layer
- **35**: p-type semiconductor layer
- **36**: n-side electrode
- **37**: p-side electrode
- **101**: Light-emitting device
- **102**: External substrate
- **102**a: First electrode
- **102**b: Second electrode
- **103**: Light-emitting body
- **103**a: First wire
- **103**b: Second wire
- **104**: Fluorescent lens
- **104**a: Fluorescent layer
- **104**a: Diffusion layer
- **105**: Light-emitting-body-side vacuum heat insulation layer
- **106**: Light reflector plate
- **107**: Sealing resin
- **108**: Phosphor
- **109**: Heat insulating material
- **115**: Lens-side vacuum heat insulation layer
- **116**: Reflector member
- **118**: Diffusion material
- **121**: Communicating hole
- **122**: Blocking member
- **131**: Growth substrate
- **132**: Semiconductor laminate
- **133**: n-type semiconductor layer
- **134**: Light-emitting layer
- **135**: p-type semiconductor layer
- **136**: n-side electrode
- **137**: p-side electrode

### EMBODIMENT FOR CARRYING OUT THE INVENTION

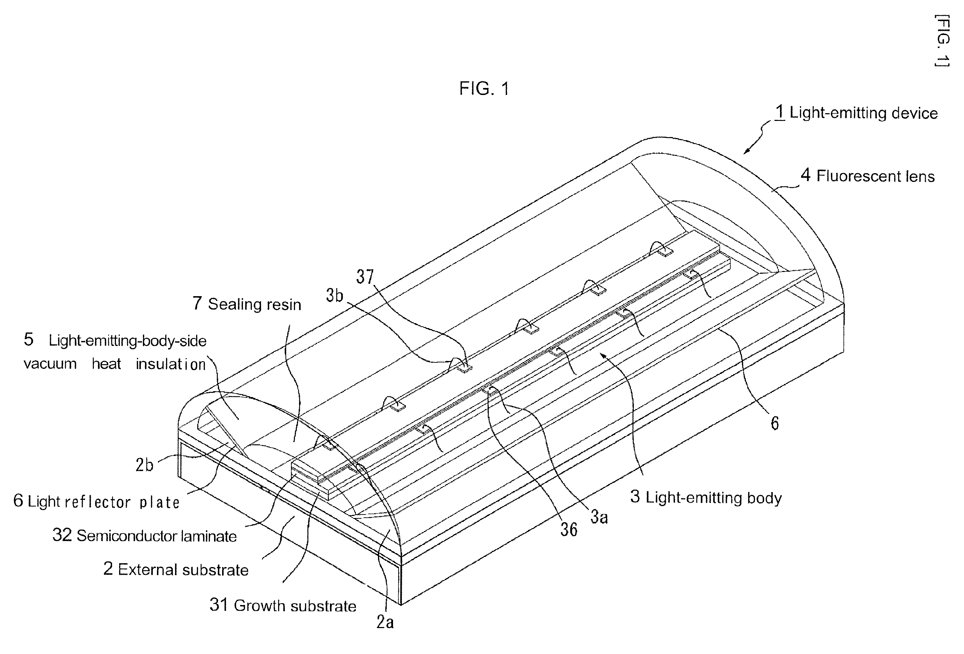

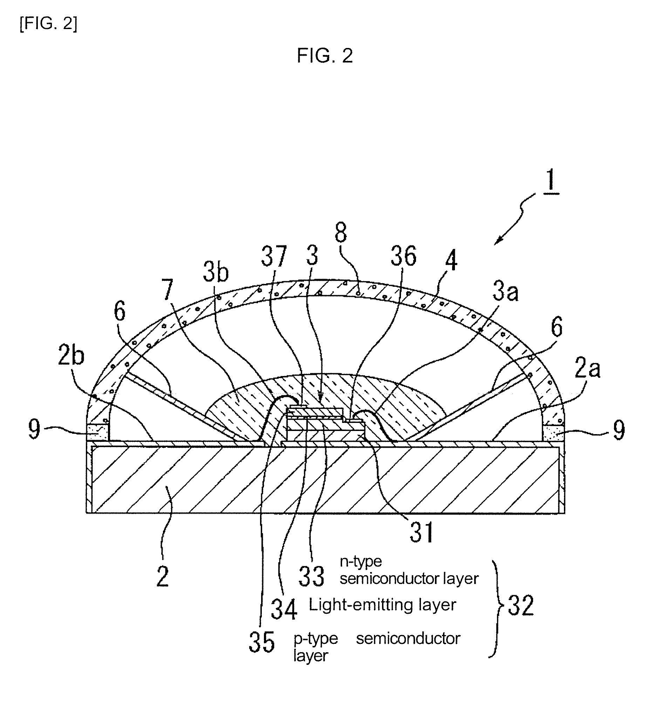

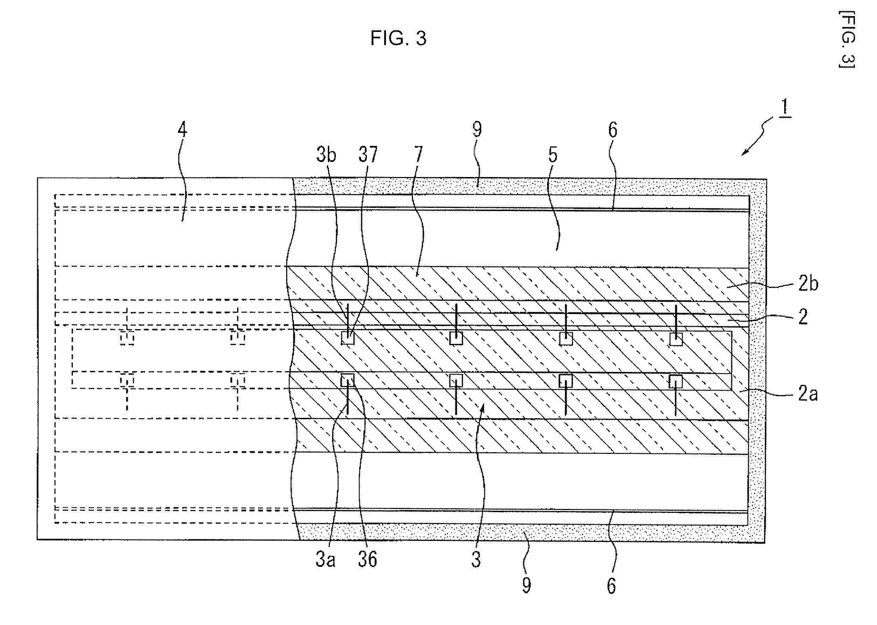

FIG.**1** to FIG.**3** show a first embodiment of the present invention, and FIG.**1** is an external explanatory view showing a light-emitting device, FIG.**2** is a schematic vertical sectional view showing the light-emitting device, and FIG.**3** is a plan view showing the light-emitting device.

As shown in FIG.**1**, a light-emitting device **1** includes an external substrate **2** as a plate-like heat dissipation member, a light-emitting body **3** mounted on the external substrate **2**, which emits linear light, a fluorescent lens **4** covering the light-emitting body **3** on the external substrate **2**, and a light-emitting-body-side vacuum heat insulation layer **5** formed between the fluorescent lens **4** and the light-emitting body **3**. In addition, the light-emitting body **3** has a growth substrate **31**, and a semiconductor laminate **32** formed on the growth substrate **31** by epitaxial growth. The light-emitting device **1** also includes a light reflector plate **6** on the external substrate **2**, which reflects the light emitted from the light-emitting body **3** in a predetermined direction.

The external substrate **2** is, for example, an interposer made of an inorganic material and having excellent heat dissipation properties. In the light-emitting device **1** shown in FIG.**1**, the external substrate **2** functions as a heat dissipation member on its own, but it is also possible to connect a heat sink to the external substrate **2**. In the embodiment, the external substrate **2** is made of a ceramic such as AIM and, in a planar view, is formed in a rectangular shape extending in a predetermined direction.

As shown in FIG.**3**, the light-emitting body **3** extends in the same direction as the external substrate **2** in a planar view, and emits light linearly on the rectangular external substrate **2**. Further, the light-emitting body **3** can be formed not only in a linear shape, but also in a planar shape extending along two directions of the longitudinal and lateral directions of the external substrate **2**. In the embodiment, the light-emitting body **3** is a face-up type, while the growth substrate **31** of the light-emitting body **3** is made of sapphire, and the semiconductor laminate **32** is made of gallium nitride (GaN) based material. As shown in FIG.**2**, the semiconductor laminate **32** has an n-type semiconductor layer **33**, a light-emitting layer **34**, and a p-type semiconductor layer **35**, respectively from the side of the growth substrate **31**, and an n-side electrode **36** and a p-side electrode **37** are formed on the n-type semiconductor layer **33** and the p-type semiconductor layer **35** respectively. Further, after partially exposing the n-type semiconductor layer **33** by removing parts of the light-emitting layer **34** and the p-type semiconductor layer **35** by etching, the n-side electrode **36** is formed thereupon. The electrodes **36** and **37** are electrically connected to a first electrode **2**a and a second electrode **2**b on the external substrate **2** via a first wire **3**a and a second wire **3**b respectively. In the embodiment, a plurality of the first wires **3**a and second wires **3**b are installed along the extension direction of the light-emitting body **3** as shown in FIG.**3**.

In addition, the light-emitting body **3** emits blue light of which peak wavelength is, for example, **460** nm. In addition, the light-emitting body **3** is sealed with a transparent resin **7** such as epoxy resin or silicon. This transparent resin **7** does not contain any phosphor, so that the light emitted from the light-emitting body **3** passes through it without modification. The transparent resin **7** is preferably a highly heat-resistant resin. Further, it is also possible to seal the light-emitting body **3** with an inorganic material such as glass.

In addition, as shown in FIG.**3**, the light-emitting body **3** is mounted on the center part in the width direction of the external substrate **2**. Furthermore, the light-emitting body **3** is formed of one LED element extending in the same direction as the extension direction of the external substrate **2**. Namely, the light-emitting device **1** is entirely different in morphology from the LED print head in which the light-emitting body is mounted on the end parts in the width direction of the external substrate, and which is formed of a plurality of elements.

As shown in FIG.**2**, the fluorescent lens **4** is made of a transparent material such as glass, and contains a phosphor **8**. The glass used in the lens **4** preferably has a low melting point. Further, it is also possible to form the fluorescent lens **4** from a transparent material other than glass, such as fiber-reinforced plastics (FRP). When the phosphor **8** is excited by the light emitted from the light-emitting body **3**, it emits a light with a different wavelength to that of the light. In the embodiment, the light-emitting body **3** is a yellow phosphor which emits a yellow light when excited by a blue light, and for example, yttrium aluminum garnet (YAG), silicate or the like is used. In addition, the fluorescent lens **4** is installed via a heat-insulating material **9** disposed on the outer edge of the upper surface of external substrate **2**. In other words, the heat insulating material **9** is formed so as to enclose the inner side of external substrate **2** in a planar view. By welding the fluorescent lens **4** to the heat insulating material **9**, it is possible to keep the fluorescent lens **4** airtight. While the material of the heat insulating material **9** is optional, it is possible to use, for example, phenol resin, epoxy resin, melamine resin or silicone resin. The fluorescent lens **4** has a semi-elliptical shape which extends in the same direction as the extension direction of external substrate **2**, and is formed to substantially align with the external substrate **2** in a planar view.

The light-emitting-body-side vacuum heat insulation layer **5** is formed by decompressing a gas, such as air, below atmospheric pressure. Here, the term "vacuum" does not mean a state that matter is completely absent, but a state that the gas is decompressed to the extent that it possesses a thermal insulating action. The internal pressure of light-emitting-body-side vacuum heat insulation layer **5** is preferably not more than **15** Torr, more preferably not more than **1.0** Torr, and even more preferably not more than **0.1** Torr. In addition, it is also possible to make the internal pressure of light-emitting-body-side vacuum heat insulation layer **5** not more than **10-5** Torr, or not more than **10-9** Torr.

The light reflector plate **6** is formed of a heat insulating material, and is disposed in a pair on both sides in the width direction of the light-emitting body **3**. The material of light reflector plate **6** is optional, but it is possible to use, for example, phenol resin, epoxy resin, melamine resin or silicone resin. As shown in FIG.**2**, the light reflector plate **6** divides the space between the external substrate **2** and the fluorescent lens **4**. On the surface of the light reflector plate **6**, a thin metallic film such as an aluminum film with relatively high reflectivity is preferably formed.

According to the light-emitting device **1** configured as stated above, when the light-emitting body **3** is energized via the first conductor **2**a and second conductor **2**b of the external substrate **2**, blue light is caused to be emitted from the light-emitting body **3**, and this blue light then directly or indirectly enters the fluorescent lens **4**. Blue light emitted in the direction of the light reflector plate **6** is reflected by the light reflector plate **6** and indirectly enters the fluorescent lens **4**. Part of the blue light which enters the fluorescent lens **4** is converted to yellow light by the phosphor **8**, and a mixture light of blue light and yellow light is then radiated from the luorescent lens **4** to the outside. When this occurs, the mixed light is optically controlled by the surface of the fluorescent lens **4** and radiated in a desired direction. This is how white light is radiated from the light-emitting device **1**.

In the embodiment, the semiconductor laminate **32** extends in a predetermined direction, so that a relatively large current can be passed through the semiconductor laminate **32** via a plurality of the wires **3**a and **3**b, and the light-emitting body **3** of a linear shape can be caused to emit light at an arbitrary luminance. This is how the device can achieve high luminance.

Most of the heat generated in the light-emitting body **3** when it emits light is transmitted to the side of the external substrate **2**, and this heat is hardly transmitted to the side of the fluorescent lens **4** due to heat insulation by the light-emitting-body-side vacuum heat insulation layer **5**, thereby deterioration of the phosphor **8** contained in the fluorescent lens **4** can be inhibited. In addition, since heat is not transmitted from the mounting portion of the light-emitting body **3** towards the fluorescent lens **4**, in case that the light-emitting body **3** is used as a lighting fixture for illuminating indoor spaces or objects to be illuminated, the illuminated indoor space or object is not heated or thermally influenced by the light-emitting device **1**. Furthermore, the heat generated in the semiconductor laminate **32** is hardly transmitted to the side of the fluorescent lens **4**, thereby deterioration of the phosphor **8** contained in the fluorescent lens **4** can be inhibited and the color of light emitted by the device can be inhibited from changing over time. It is therefore possible to exploit the inherently long life of the LED in the light-emitting body **3** without having to consider the deterioration of the phosphor **8**.

The heat dissipation member is formed in a plate-like shape, so that the heat emission area can be easily increased, heat dissipation performance can be enhanced, and the device can be slimmed down, consequently it is very useful in practical applications. By installing the light reflector plate **6**, the light emitted from the light-emitting body **3** can be effectively extracted.

In addition, according to the embodiment, the heat radiated from the light-emitting body **3** is transmitted from the center side to the both end sides in the width direction of the external substrate **2**. Due to this, the heat generation can be efficiently dissipated in comparison with a case that the light-emitting body **3** is mounted on the end parts in the width direction of the external substrate **2**. Furthermore, according to the light-emitting device **1**, the light-emitting body **3** is formed of one element, so that variation in luminance, chromaticity and the like in the element is not visually recognized different from a case that the light-emitting body **3** is formed of a plurality of elements adjacent to each other.

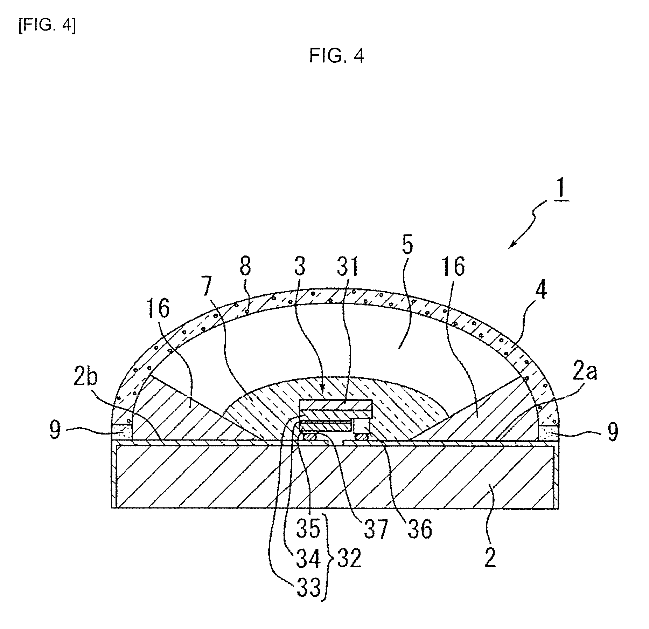

Further, although the light-emitting body **3** shown in the above-described embodiment was the face-up type, the light-emitting body **3** may also be a flip-chip type, for example, as shown in FIG.**4**. It is also possible to change the emission wavelength and materials of the light-emitting body **3** as desired. For example, the light-emitting body **3** may also emit ultraviolet light, and the fluorescent lens **4** may contain blue, green and red phosphor excited by the ultraviolet light. In addition, it is also possible to obtain white light without including phosphor by combining a plurality of types of the light-emitting body **3** each having different emission wavelengths. Furthermore, instead of using the growth substrate **31**, the substrate of the light-emitting body **3** can also be a support substrate laminated after epitaxial formation.

In addition, a pair of the light reflector plate **6** dividing the space between the fluorescent lens **4** and the external substrate **2** was shown in the above-described embodiment, but it is also perfectly acceptable to install a reflector member **16** having a reflective surface on the external substrate **2**, for example, as shown in FIG.**4**.

The light-emitting body **3** sealed by the sealing resin **7** was shown in the above-described embodiment, but the light-emitting body **3** is sealed with glass, so that the device can be further improved in heat resistance.

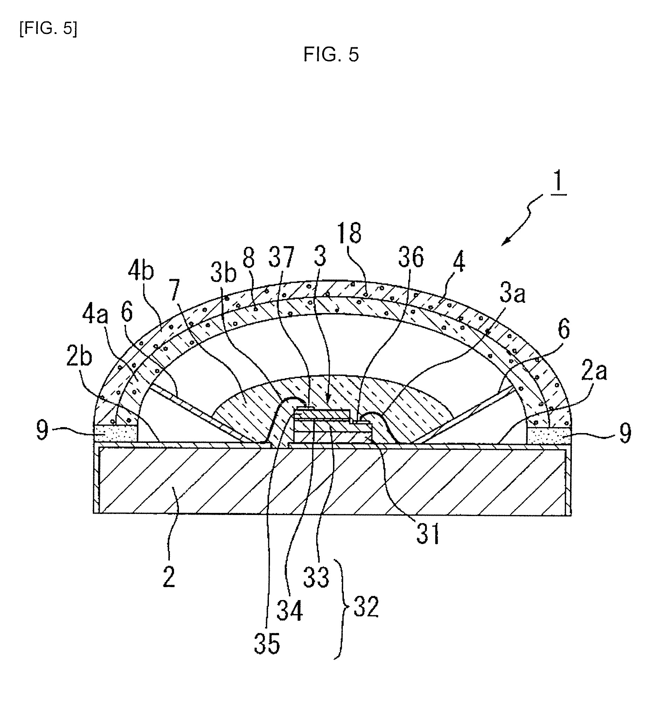

In addition, it is also acceptable for the fluorescent lens **4** to have, for example, a double-layered structure comprised of a fluorescent layer **4**a on the inside and a diffusion layer **4**b on the outside as shown in FIG.**5**. The phosphor **8** is dispersed in the fluorescent layer **4**a on the inside, while a diffusion material **18** is dispersed in the diffusion layer **4**b on the outside. Furthermore, the fluorescent lens **4** could also be glass to which predetermined elemental ions have been added, whereby the ions would emit light upon being struck by excitation light from the light-emitting body **3**.

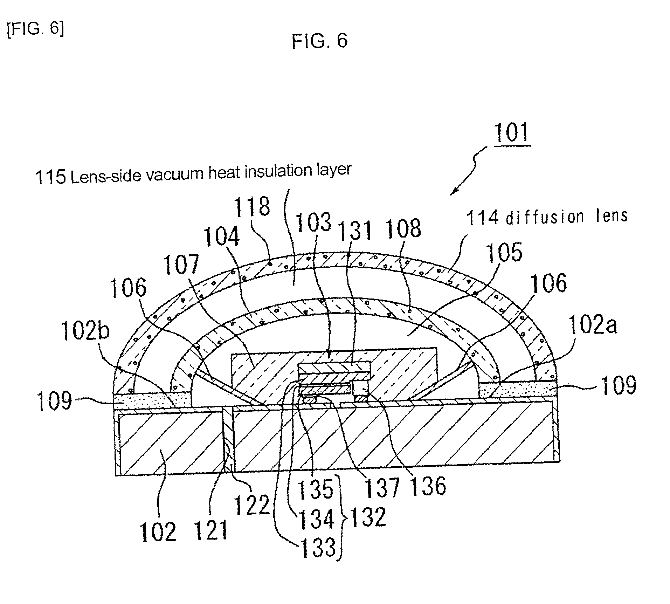

FIG.**6** is a schematic vertical sectional view showing a light-emitting device according to a second embodiment of the present invention. As shown in FIG.**6**, a light-emitting device **101** includes an external substrate **102** as a plate-like heat dissipation member, a light-emitting body **103** mounted on the external substrate **102**, which emits linear light, a fluorescent lens **104** covering the light-emitting body **103** on the external substrate **102**, and a light-emitting-body-side vacuum heat insulation layer **105** formed between the fluorescent lens **104** and the light-emitting body **103**. The light-emitting device **101** also includes a diffusion lens **114** covering the outside of the fluorescent lens **104**, and diffusing light passing through the fluorescent lens **104** and, the lens-side vacuum heat insulation layer **115** formed between the diffusion lens **114** and the fluorescent lens **104**. In addition, the light-emitting body **103** has a growth substrate **131**, and a semiconductor laminate **132** formed on the growth substrate **131** by epitaxial growth. The light-emitting device **101** also includes a light reflector plate **106** on the external substrate **102**, which reflects the light emitted by the light-emitting body **103** in a predetermined direction.

The external substrate **102** is made of a ceramic such as AIN and, in a planar view, is formed in a rectangular shape extending in a predetermined direction. In the external substrate **102**, there is formed a communication hole **121**, which communicates the outside of the device with the light-emitting-body-side vacuum heat insulation layer **105**, and the communication hole **121** is blocked by a blocking member **122**.

The light-emitting body **103** extends in the same direction as the external substrate **102** in a planar view, and emits light linearly on the external substrate **102** of a rectangular shape. The semiconductor laminate **132** has an n-type semiconductor layer **133**, a light-emitting layer **134**, and a p-type semiconductor layer **135**, respectively from the side of growth substrate **131**, in addition, an n-side electrode **136** and a p-side electrode **137** are formed on the n-type semiconductor layer **133** and the p-type semiconductor layer **135** respectively. Further, the light-emitting body **103** can be formed not only in a linear shape, but also in a planar shape extending along two directions of the longitudinal and lateral directions of the external substrate **102**. In the embodiment, the light-emitting body **103** is a flip-chip type. In addition, the light-emitting body **103** emits blue light of which peak wavelength is, for example, **460** nm. The light-emitting body **103** is sealed with a transparent resin **107**.

In addition, the light-emitting body **103** is mounted on the center part in the width direction of the external substrate **2**. Furthermore, the light-emitting body **103** is formed of one LED element extending in the same direction as the extension direction of the external substrate **102**. Namely, the light-emitting device **101** is entirely different in morphology from the LED print head in which the light-emitting body is mounted on the end parts in the width direction of the external substrate, and which is formed of a plurality of elements.

The fluorescent lens **104** is made of a transparent material such as glass, and contains a phosphor **108**. When the phosphor **108** is excited by the light emitted from the light-emitting body **103**, it emits a light with a different wavelength from that of the light.
In the embodiment, the light-emitting body **103** is a yellow phosphor which emits a yellow light when excited by a blue light. Further, the fluorescent lens **104** could also be glass to which predetermined elemental ions have been added, whereby the glass itself would emit fluorescence. For example, by adding trivalent praseodymium ions to glass, a blue light, a green light and a red light are emitted from the praseodymium ions as luminescence centers when excited by the blue light.

The diffusion lens **114** is, for example, made of a transparent material such as glass, and contains a diffusion material **118**. In the embodiment, the diffusion material **118** is, for example, ceramic particles such as TiO₂ and SiO₂. Further, the diffusion lens **114** may have a diffusion layer on its surface instead of containing the diffusion material **118**. It is also possible to form the diffusion lens **114** from a transparent material other than glass, such as fiber-reinforced plastics (FRP).

In addition, the diffusion lens **114** is structured not to transmit ultraviolet light, so that it can block external ultraviolet light from penetrating. Here, ultraviolet light means a light with a wavelength of not more than **400** nm. Examples of structures which prevent transmission of ultraviolet light include those using ultraviolet blocking materials as the transparent material of the diffusion lens **114**, and those having an ultraviolet -blocking diffusion layer installed on the surface of the diffusion lens **114**. Examples of the ultraviolet blocking materials include a UV cut glass and a UV cut resin. An example of the diffusion layer opaque to ultraviolet light includes an ultraviolet-absorbing film.

In addition, diffusion lens **114** is installed via a heat-insulating material **109** disposed on the outer edge of the upper surface of the external substrate **102**. In addition, the fluorescent lens **104** is also installed via the heat-insulating material **109**. The heat insulating material **109** is formed so as to enclose the inner side of external substrate **102** in a planar view. By welding the diffusion lens **114** to the heat insulating material **109**, it is possible to keep the diffusion lens **114** airtight. While the material of the heat insulating material **109** is optional, it is possible to use, for example, phenol resin, epoxy resin, melamine resin or silicone resin. The diffusion lens **114** has a semi-elliptical shape in section which extends in the same direction as the extension direction of the external substrate **102**, and is formed to substantially align with the external substrate **102** in a planar view.

In addition, the fluorescent lens **104** is installed on the inner side of the diffusion lens **114**, and has a similar sectional shape to that of the diffusion lens **114**. The fluorescent lens **104** is formed shorter than the diffusion lens **114**, and the interior and exterior of the fluorescent lens **104** are communicated with each other at both ends in the extension direction.

The light-emitting-body-side vacuum heat insulation layer **105** and the lens-side vacuum heat insulation layer **115** are formed by decompressing a gas, such as air, below atmospheric pressure. In the embodiment, the light-emitting-body-side vacuum heat insulation layer **105** and the lens-side vacuum heat insulation layer **115** are communicated with each other at both ends of the fluorescent lens **104**, so that they have the same internal pressure. The internal pressure is preferably not more than **15** Torr, more preferably not more than **1.0** Torr, and even more preferably not more than **0.1** Torr. It is also possible to make the internal pressure not more than **10-5** Torr, or not more than **10-9** Torr.

The light reflector plate **106** is made of a heat insulating material, and is disposed in a pair on both sides in the width direction of the light-emitting body **103**. The material of the light reflector plate **106** is optional, but it is possible to use, for example, phenol resin, epoxy resin, melamine resin or silicone resin. As shown in FIG.**2**, the light reflector plate **106** divides the space between the external substrate **102** and the fluorescent lens **104**, and the space between external substrate **102** and diffusion lens **114**. On the surface of the light reflector plate **106**, a thin metallic film such as an aluminum film with relatively high reflectivity is preferably formed.

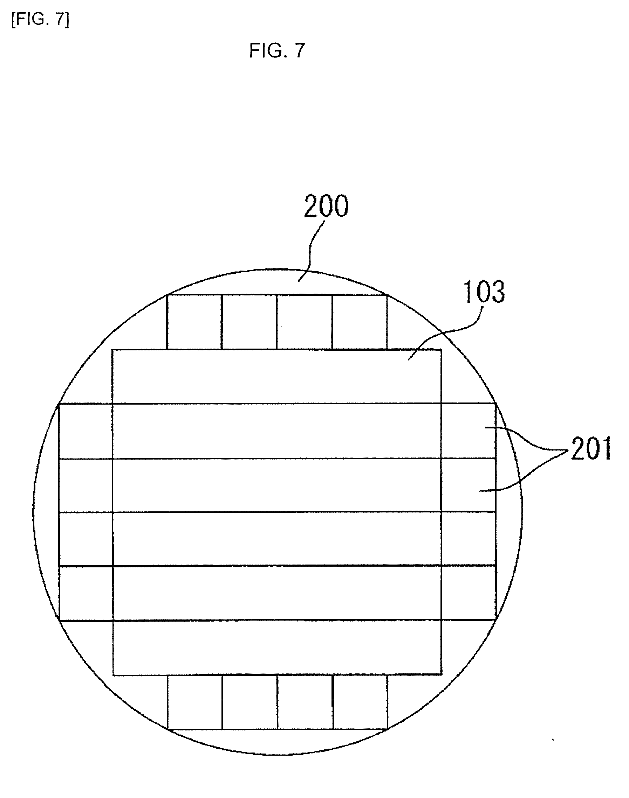

The light-emitting device **1** configured as described above is manufactured as follows. FIG.7 is a plan view schematically showing a semiconductor wafer.
As shown in FIG.**7**, the light-emitting body **103** is fabricated by cutting a disk-shaped semiconductor wafer **200** formed by a semiconductor laminate **32** on the growth substrate **31**. In the center area of the semiconductor wafer **200**, a plurality of long light-emitting bodies **103** are formed in the width direction adjacent to each other. And, at each outer end of each light-emitting body **103** on the semiconductor wafer **200**, a substantially square-shaped light-emitting body **201** used in a point light source LED is formed.

In addition, the external substrate **102** is prepared separately to the light-emitting body **103**, and the light reflector plate **106** is installed on the external substrate **102**. The light-emitting body **103** is subsequently flip-chip mounted on the external substrate **102** and sealed with the sealing resin **107**. In the embodiment, the sealing resin **107** is formed by bonding the resin tape covering the light-emitting body **103** to the upper surface of the external substrate **102**. This facilitates the process of sealing the light-emitting body **103**.

Next, the heat insulating material **109** to which the fluorescent lens **104** and the diffusion lens **114** are welded, is disposed on the external substrate **102**. At this point, it is preferable for the heat insulating material **109** and the external substrate **102** to be joined by welding also.
Then, after discharging the air via a discharge port **121** on the external substrate **102** so as to create a vacuum in the light-emitting-body-side vacuum heat insulation layer **105** and the lens-side vacuum heat insulation layer **115**, the discharge port **121** is blocked using a blocking member **122**.

According to the light-emitting device **101** configured as stated above, when the light-emitting body **103** is energized via the first conductor **102**a and the second conductor **102**b of the external substrate **102**, blue light is caused to be emitted from the light-emitting body **103**, and this blue light then directly or indirectly enters the fluorescent lens **104**. Part of the blue light which enters the fluorescent lens **104** is converted to yellow light by the phosphor **108**, and a mixture light of blue light and yellow light is then radiated from the fluorescent lens **104** to the side of the diffusion lens **114**. The mixed light radiated to the side of the diffusion lens **114** is diffused by the diffusion lens **114** then optically controlled by the surface of diffusion lens **114** and radiated in a desired direction. This is how white light is radiated from the light-emitting device **101**.

In addition, according to the light-emitting device **101**, the semiconductor laminate **132** extends in a predetermined direction, so that a relatively large current can be passed through the semiconductor laminate **132**, which can in turn cause light to be emitted from the linear light-emitting body **103** at an arbitrary luminance. In addition, the semiconductor laminate **132** extends in a predetermined direction, so that the light emission area can be relatively increased, and the light emission state that is can be realized along the extension direction of semiconductor laminate **132**. Furthermore, the external substrate **102** extends in the same direction as the extension direction of the light-emitting body **103**, so that the dissipation area of the external substrate **102** can be increased, and heat transmission that is approximately uniform can be realized along the extension direction of the external substrate **102**, and further heat dissipation performance of the device can be improved.

Most of the heat generated in semiconductor laminate **132** is transmitted to the side of external substrate **102**, and this heat is hardly transmitted to the side of the fluorescent lens **104** due to heat insulation by the light-emitting-body-side vacuum heat insulation layer **105**, so that deterioration of the fluorescent lens **104** can be inhibited. Furthermore, the heat generated in the semiconductor laminate **132** is hardly transmitted to the side of the fluorescent lens **104**, so that deterioration of the phosphor **108** contained in the fluorescent lens **104** can be inhibited and the color of light emitted by the device can be inhibited from changing over time. It is therefore possible to exploit the inherently long life of the LED in the light-emitting body **103** without having to consider the deterioration of the phosphor **108**.

In addition, according to the light-emitting device **101** of the embodiment, the diffusion lens **114** diffuses the light which passes through the fluorescent lens **104**, so that the light emission state can be further homogenized. Also, the light-emitting-body-side vacuum heat insulation layer **115** is formed, so that heat applied to the diffusion lens **114** from the outside of the device is hardly transmitted to the fluorescent lens **104**, and deterioration of the phosphor **108** of the fluorescent lens **104** due to heat generation factor at the outside of the device can be inhibited. Furthermore, external ultraviolet light does not pass through the diffusion lens so as to penetrate the fluorescent lens, so that deterioration of the fluorescent lens due to ultraviolet light can be inhibited. Accordingly even if the light-emitting device **101** is used outdoors, the fluorescent lens **104** is not deteriorated by the ultraviolet light contained in sunlight.

According to the light-emitting device **101** of the embodiment, the diffusion lens **114** is installed on the external substrate **102** via the heat insulating material **109**, so that the heat generated in the semiconductor laminate **132** is hardly transmitted to the side of diffusion lens **114**, and deterioration of the diffusion lens **114** can be inhibited. In addition, heat is not transmitted from the mounting portion of the light-emitting body **103** towards the diffusion lens **114**, when the light-emitting body **103** is used as a lighting fixture for illuminating indoor spaces or objects to be illuminated, the illuminated indoor space or object is not heated or thermally influenced by the light-emitting device **101**.

Furthermore, the diffusion lens **114** and the heat insulating material **109** are welded, so that they can be joined together without interstices, and in case that the inside of the diffusion lens **114** is vacuated, airtightness thereof can be adequately ensured.
In addition, according to the light-emitting device **101** of the embodiment, the fluorescent lens **104** and the diffusion lens **114** are made of glass, so that their resistance to heat, weather and the like can be enhanced compared to lenses made from resin.

According to the light-emitting device **101** of the embodiment, heat generated from the light-emitting body **103** is transmitted from the center side to the both end sides in the width direction of the external substrate **102**. Due to this, the heat generation can be efficiently dissipated in comparison with a case that the light-emitting body **103** is mounted on the end parts in the width direction of the external substrate **102**. Furthermore, according to the light-emitting device **101**, the light-emitting body **103** is formed of one element, so that variation in luminance, chromaticity and the like in the element is not visually recognized different from a case that the light-emitting body **103** is formed of a plurality of elements adjacent to each other.

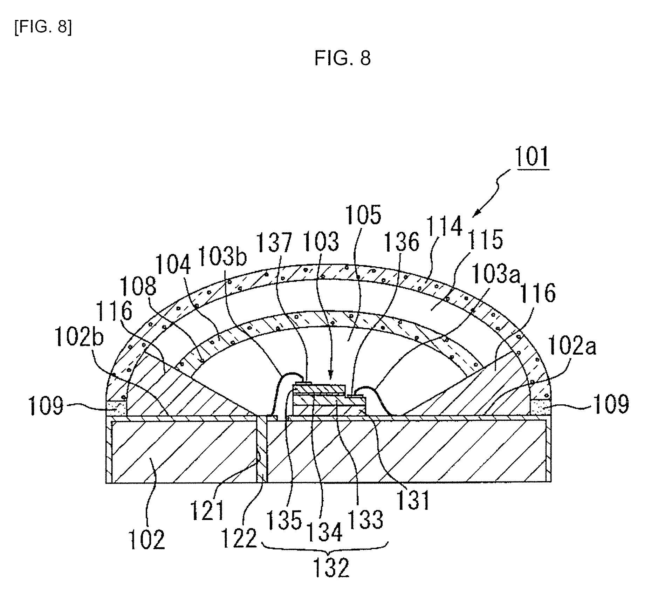

Further, in the second embodiment, the light-emitting body **103** sealed with the sealing resin **107** is shown, but, as shown in FIG.**8**, for example, it is also possible for the sealing material such as the sealing resin **107** to be omitted, and for the light-emitting body **103** to adopt an unsealed structure. This prevents the light radiated from the light-emitting device **101** from changing over time as a result of deterioration of the sealing material. In addition, the process of the sealing light-emitting body **103** can also omitted when manufacturing the device, so that the manufacturing costs can be reduced.

In the light-emitting device **101** shown in FIG.**8**, the light-emitting body **103** is a face-up type bonded to the external substrate **102** with a double-sided tape (not shown), and electrically connected to the first electrode **102**a and the second electrode **102**b via the first wire **103**a and the second wire **103**b. Even if the sealing resin **107** is omitted as described above, the light-emitting body **103** is hermetically sealed by the diffusion lens **114**, the external substrate **102** and the like, so that it can prevent the wires **103**a and **103**b from being disconnected due to application of a load, and dust and the like from adhering to the light-emitting body **103**. Furthermore, the inside of the device is kept in the vacuum state, so that it can prevent the light-emitting body **103** and the wires **103**a, **103**b from chemically reacting with atmospheric gases.

In the light-emitting device **101** shown in FIG.**8**, the reflector member **116** formed of a heat insulating material with a reflective surface, is installed on the external substrate **102**. Here, it is also possible for the reflector member **116** to be integrally formed with the external substrate **102**. In this case, it is preferable that a heat insulating material is installed in the whole surface of the contact portion between the reflector member **116** and the fluorescent lens **104** and diffusion lens **114**.

The diffusion lens **114** described in the second embodiment does not transmit ultraviolet light, but it is also possible to prevent external ultraviolet light from penetrating, for example, by forming an ultraviolet reflective film on the surface.
In addition, the light-emitting body **103** may emit ultraviolet light, and the fluorescent lens **104** may contain blue, green and red phosphor excited by the ultraviolet light. In this case, the diffusion lens **114** is configured so as not to transmit ultraviolet light, so that it can prevent ultraviolet light from being discharged externally from the light-emitting body **103**.

The light-emitting body **103** described in the second embodiment is formed of one element, but even if the light-emitting body **103** is formed of any configuration such as being formed of a plurality of elements, if the light-emitting device **101** includes the light-emitting-body-side vacuum heat insulation layer **105** and the lens-side vacuum heat insulation layer **115**, it is naturally expected that thermal insulating effect due to these layers can be obtained.

Although the typical embodiments of the present invention have been explained above, the present invention is not necessarily limited to the structures of these embodiments, and it is certainly possible to arbitrarily modify the specific detailed structure and the like.

### INDUSTRIAL APPLICABILITY

The light-emitting device of the present invention can be used as an alternative to a lighting fixture such as an incandescent lamp, a mercury lamp, a fluorescent lamp and the like. Namely, the light-emitting device of the present invention is different in the technical field from the LED print head that is not used for illumination, and simultaneously does not share common actions and functions with the LED print head.

## Claims

1. A light-emitting device comprising:
a plate-like heat dissipation member;
a light-emitting body emitting linear or planar light, which is mounted on the heat dissipation member, and which has a substrate, and a semiconductor laminate extending in a predetermined direction and including a first conductivity-type first semiconductor layer, a light-emitting layer, and a second conductivity-type second semiconductor layer;
a fluorescent lens covering the light-emitting body on the heat dissipation member, which emits light with a different wavelength from the light of the light-emitting body when excited by the light;
a light-emitting-body-side vacuum heat insulation layer formed between the fluorescent lens and the light-emitting body;
a diffusion lens covering the outside of fluorescent lens, which diffuses light passing through the fluorescent lens; and
a lens-side vacuum heat insulation layer formed between the diffusion lens and the fluorescent lens;
wherein the heat dissipation member extends in the same direction as the extending direction of the light-emitting body.

2. The light-emitting device according to claim **1**, wherein the diffusion lens inhibits external ultraviolet light from penetrating.

3. The light-emitting device according to claim **1** or **2**, wherein the light-emitting device further comprises a heat insulating material that is provided on the outer edge side of the heat dissipation member's upper surface, and the diffusion lens is disposed on the heat dissipation member via the heat insulating material.

4. The light-emitting device according to claim **3**, wherein the diffusion lens is welded on the heat insulating material.

5. The light-emitting device according to claim **4**, wherein the fluorescent lens is disposed on the heat dissipation member via the heat insulating material.

6. The light-emitting device according to any one of claims **3** to **5**, wherein the fluorescent lens and the diffusion lens are made of glass.
